# EUROPEAN PATENT SPECIFICATION

(11) **EP 2 889 918 B1**
(45) Date of publication and mention of the grant of the patent: **02.08.2017**
(21) Application number: 14162221.7
(22) Date of filing: 28.03.2014
(51) Int. Cl.: H01L 31/0304, H01L 31/0352, H01L 31/0376, H01L 31/0392, H01L 31/075, H01L 31/18, H01L 31/20, H01L 21/02

(54) **Preparation method of solar cell with stainless steel substrate of adjustable bandgap quantum well structure**
Herstellungsverfahren von Solarzelle mit Edelstahlsubstrat mit anpassbarer Bandabstand-Quantentopfstruktur
Procédé de préparation d'une cellule solaire avec substrat en acier inoxydable de structure à puits quantique à bande interdite réglable

(30) Priority: 30.12.2013 CN 201310746388
(43) Date of publication of application: 01.07.2015
(73) Proprietor: Shenyang Institute of Engineering, Shenyang Liaoning 110136 (CN)
(72) Inventor: Zhang, Tieyan, 110136 Shenyang Liaoning (CN); Zhang, Dong, 110136 Shenyang Liaoning (CN); Ju, Zhenhe, 110136 Shenyang Liaoning (CN); Zhao, Yan, 110136 Shenyang Liaoning (CN); Li, Yucai, 110136 Shenyang Liaoning (CN); Song, Shiwei, 110136 Shenyang Liaoning (CN); Wang, Jian, 110136 Shenyang Liaoning (CN); Wang, Gang, 110136 Shenyang Liaoning (CN); Bian, Jiming, 110136 Shenyang Liaoning (CN); Liu, Baodan, 110136 Shenyang Liaoning (CN)
(74) Representative: Office Kirkpatrick

(56) References cited:
- US-A1- 2007 175 507
- US-A1- 2010 200 837
- US-A1- 2012 164 767
- DIRK V. P. MCLAUGHLIN ET AL: "Progress in Indium Gallium Nitride Materials for Solar Photovoltaic Energy Conversion", METALLURGICAL AND MATERIALS TRANSACTIONS A, vol. 44, no. 4, 1 February 2013 (2013-02-01), pages 1947-1954, XP055149844, ISSN: 1073-5623, DOI: 10.1007/s11661-013-1622-1
- XING-LONG LIU ET AL: "The Preparation and Characteristics of In x Ga 1- x N (0.06 <= x <= 0.58) Films Deposited by ECR-PEMOCVD", CHINESE PHYSICS LETTERS, vol. 28, no. 10, 1 October 2011 (2011-10-01), page 108104, XP055150153, ISSN: 0256-307X, DOI: 10.1088/0256-307X/28/10/108104
- WU JUNQIAO: "When group-III nitrides go infrared: New properties and perspectives", JOURNAL OF APPLIED PHYSICS, AMERICAN INSTITUTE OF PHYSICS, US, vol. 106, no. 1, 1 July 2009 (2009-07-01), pages 11101-11101, XP012123358, ISSN: 0021-8979, DOI: 10.1063/1.3155798
- YAN BAOJIE ET AL: "On the bandgap of hydrogenated nanocrystalline silicon intrinsic materials used in thin film silicon solar cells", SOLAR ENERGY MATERIALS AND SOLAR CELLS, vol. 111, 23 January 2013 (2013-01-23), pages 90-96, XP028981752, ISSN: 0927-0248, DOI: 10.1016/J.SOLMAT.2012.12.038
- Yun Jeong Hwang ET AL: "Si/InGaN Core/Shell Hierarchical Nanowire Arrays and their Photoelectrochemical Properties", Nano Letters, vol. 12, no. 3, 14 March 2012 (2012-03-14) , pages 1678-1682, XP055289737, US ISSN: 1530-6984, DOI: 10.1021/nl3001138

## Description

### Technical Field

The present invention belongs to the field of flexible solar cell manufacturing technology, in particular relates to a solar cell with a stainless steel substrate of an adjustable bandgap quantum well structure and a preparation method therefor.

### Background

Crystalline silicon solar cell, which is the first generation of solar cell, plays a leading role in the present industrial production and market due to high conversion efficiency. However, high raw material consumption and high cost have become the main obstacles for the development of solar cell. In order to save raw material and further promote the development of solar cell, thin film solar cell becomes a research hot spot in recent years.
The structure of the conventional thin film solar cell uses rigid material and toughened glass as the substrate, which limits the application range of solar cell. With the cost becoming lower and lower, more and more solar cells are used in civil fields, such roof, schoolbag and tent. As a portable power source, the solar cell is required to have a flexible substrate.
A solar cell with a flexible substrate refers to a thin film solar cell which is made on a flexible material, i.e. polyimide (PI) or flexible stainless steel. With the advantages of portability, light weight, non-frangible property and unique operational performance, and the thin film solar cell has strong market competitiveness.
Currently, most of the thin film solar cells with relatively mature technology are made of silicon-based material, and the I layers in PIN are generally noncrystalline or microcrystalline silicon (Si) films. The noncrystalline or microcrystalline silicon (Si) is also called amorphous silicon. As can be seen from its microscopic structure, amorphous silicon has a short-range ordered but long-range disordered random network structure with the defect of containing a large number of dangling bonds and vacancies. However, since the bandgap of a noncrystalline or microcrystalline silicon (Si) film is about 1.7eV, the film is not very sensitive to the long waves of solar radiation spectrum, thus the photoelectric conversion efficiency of the film is relatively low. Besides, there is a significant effect of light-induced degradation, which makes the photoluminescence property of a solar cell less stable, thus making the thin film solar cell have a poor market competitiveness.

Document "Progress in Indium Gallium Nitride Materials for Solar Photovoltaic Energy Conversion" of DIRK V. P. MACLAUGHLIN ET AL dated February 1, 2013 reviews the solar PV technology field and the basic properties of InxGa1-xN materials and PV devices.

Document US 2007/175507 discloses novel structures of photovoltaic cells. The cells are based on nanoparticles or nanometer-scaled wires, tubes, and/or rods, which are made of electronic materials covering semiconductors, insulators, and may be metallic in structure.

Document US 2010/0200837 discloses thin freestanding nitride films are used as a growth substrate to enhance the optical, electrical, mechanical and mobility of nitride based devices and to enable the use of thick transparent conductive oxides.

Document "The Preparation and Characteristics of In x Ga 1-X N (0.06 = x =0.578) Films Deposited by ECR-PEMOCVD" of XING-LONG LIU ET AL dated October 1, 2011 discloses the structural property and surface morphology of InxGa1-xN films for In compositions ranging from 0.06 to 0.58, which are deposited by electron cyclotron resonance plasma enhanced metal organic chemical vapor deposition (ECR-PEMOCVD).

Document "When group-II nitrides go infrared: New properties and perspectives" of WU JUNQIAO dated July 1, 2009 describes the progress, perspectives, and challenges in the developments of new electronic and optoelectronic devices based on InGaN alloys.

Document "On the bandgap of hydrogenated nanocrystalline silicon intrinsic materials used in thin film silicon solar cells" of YAN BAOJIE ET AL, dated December 2012 discloses optical and electrical measurements of bandgap of hydrogenated nanocrystalline silicon (nc-Si:H).
Document US 2012/164767 A1 discloses light emitting devices (LEDs) based on n-doped nanowires and comprising a stainless steel substrate.
Document "Si/InGaN core/shell hierarchical nanowire arrays and their photoelectrochemical properties" of YUN JEONG HWANG ET AL, dated March 2012 in Nano Letters discloses nanostructures consisting of InGaN nanowires deposited on Si wire arrays.

### Summary

In consideration of the shortage of the prior art, the present invention provides a preparation method for a solar cell with a stainless steel substrate of an adjustable bandgap quantum well structure. The present invention uses an InₓGa₁₋ₓN crystal film of which the bandgap can be adjusted to the most sensitive range of a solar cell as the P layer of a flexible solar cell, and the quantum well structure of the crystal film increases the photoelectric conversion efficiency of the solar cell and improves the stability of the photoluminescence property of solar cell.

A solar cell with a stainless steel substrate of an adjustable bandgap quantum well structure, using a stainless steel sheet as a flexible substrate, an AlN insulating layer is above the substrate, an Al back electrode is above the AlN insulating layer, a Ga-doped ZnO (GZO) transparent conductive film used as a buffer layer is above the Al back electrode, an N-type hydrogenated nano-crystalline silicon (nc-Si:H) film is above the GZO transparent conductive film, an I layer nc-Si:H intrinsic film is above the N-type nc-Si:H film, a P-type InₓGa₁₋ₓN film is above the I layer nc-Si:H intrinsic film, another GZO transparent conductive film is above the P-type InₓGa₁₋ₓN film, and an Al metal electrode is above the GZO transparent conductive film. The specific structure is Al electrode/GZO/P-type InₓGa₁₋ₓN/I layer nc-Si:H film/N-type nc-Si:H/GZO/Al back electrode/AIN insulating layer/flexible stainless steel substrate, wherein the P-type InₓGa₁₋ₓN film has an adjustable bandgap width and a quantum well structure.

The preparation method for the solar cell with a stainless steel substrate of an adjustable bandgap quantum well structure of the present invention comprises the steps of:
(1) After ultrasonic cleaning by ionized water, drying up the flexible stainless steel substrate by N₂ and putting the substrate into a magnetron sputtering reaction chamber to prepare the AlN insulating layer by deposition at a vacuum of 9.0 × 10⁻⁴ Pa; the process parameters are as follows: the reaction source is the gas mixture of Ar and N₂, the flow ratio of Ar:N₂ is 10:1, the target material is aluminum, the substrate is heated to 100 to 300°C, and the deposition time is 30 to 60 min. The structure at this time is AlN insulating layer/flexible stainless steel substrate.
(2) Preparing the Al metal back electrode by magnetron sputtering; the process parameters are as follows: the reaction source is Ar, the flow rate of Ar is 10 to 20 sccm, the target material is aluminum, the temperature of the substrate is 50 to 350°C, and the deposition time is 3 to 10 min. The structure at this time is Al back electrode/AIN insulating layer/flexible stainless steel substrate.
(3) Preparing one GZO transparent conductive film by an Electron Cyclotron Resonance Plasma Enhanced Chemical Vapor Deposition (ECR-PEMOCVD) system; the process parameters are as follows: Ar carried trimethyl gallium (TMGa), diethyl zinc (DEZn) and O₂ are introduced to the reaction chamber, the flow ratio of TMGa:DEZn:O₂ is 1:2:80, the microwave power is 650 W, the deposition temperature is 200 to 400°C, the deposition pressure is 0.8 to 1.2 Pa, and the deposition time is 10 to 20 min. The structure at this time is GZO/Al back electrode/AIN insulating layer/flexible stainless steel substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 5 to 8 sccm, the flow rate of H₂ diluted PH₃ is 0.5 to 5 sccm, the flow rate of H₂ is 25 to 40 sccm, the microwave power is 650 W, the deposition temperature is 250 to 600°C, the deposition pressure is 0.8 to 1.2 Pa, and the deposition time is 30 to 80 min. The structure at this time is N-type nc-Si:H/GZO/Al back electrode/AIN insulating layer/flexible stainless steel substrate.
(5) Preparing the I layer nc-Si:H intrinsic film by the ECR-PEMOCVD system and introducing Ar diluted SiH₄ and H₂ to the reaction chamber; the process parameters are as follows: the flow rate of Ar diluted SiH₄ is 5 to 8 sccm, the flow rate of H₂ is 25 to 40 sccm, the microwave power is 650 W, the deposition temperature is 250 to 600°C, the deposition pressure is 0.8 to 1.2 Pa, and the deposition time is 30 to 80 min. The structure at this time is I layer nc-Si:H intrinsic film/N-type nc-Si:H/GZO/Al back electrode/AIN insulating layer/flexible stainless steel substrate.
(6) Preparing the P-type InₓGa₁₋ₓN adjustable bandgap quantum well crystal film by the ECR-PEMOCVD system and introducing H₂ diluted TMGa, trimethyl indium (TMIn), ferrocene magnesium (Mg(C₅H₅)₂) and N₂ to the reaction chamber; the process parameters are as follows: the flow ratio of TMGa:TMIn:Mg(C₅H₅)₂ is 8:4:1, the flow rate of N₂ is 80 to 120 sccm, the microwave power is 650 W, the deposition temperature is 200 to 600°C, the deposition pressure is 0.9 to 1.4 Pa, and the deposition time is 40 to 60 min. The structure at this time is P-type InₓGa₁₋ₓN/I layer nc-Si:H intrinsic film/N-type nc-Si:H/GZO/Al back electrode/AlN insulating layer/flexible stainless steel substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the microwave power is 650 W, the deposition temperature is 200 to 400°C, the deposition pressure is 0.8 to 1.2 Pa, and the deposition time is 10 to 20 min. The structure at this time is GZO/P-type InₓGa₁₋ₓN/I layer nc-Si:H intrinsic film/N-type nc-Si:H/GZO/Al back electrode/AlN insulating layer/flexible stainless steel substrate.
(8) Preparing the Al metal back electrode by magnetron sputtering; the process parameters are as follows: the reaction source is Ar, the flow rate of Ar is 10 to 20 sccm, the target material is aluminum, the deposition temperature is 50 to 400°C, and the deposition time is 3 to 10 min. The structure at this time is Al electrode/GZO/P-type InₓGa₁₋ₓN/I layer nc-Si:H intrinsic film/N-type nc-Si:H/GZO/Al back electrode/AlN insulating layer/flexible stainless steel substrate.

The target material of aluminum used during magnetron sputtering has a purity of 99.99%.

The value of x in the InₓGa₁₋ₓN film is between 0 and 1.

Compared with prior art, the present invention has the following characteristics and advantages:

The substrate used in the solar cell with a structure of Al electrode/GZO/P-type InₓGa₁₋ₓN/I layer nc-Si:H film/N-type nc-Si:H/GZO/Al back electrode/AlN insulating layer/flexible stainless steel substrate of the present invention is a flexible stainless steel substrate, the most distinct characteristics of the flexible solar cell are light in weight, easy to carry about and not easy to crush, and the gravimetric specific power and volumetric specific power of the flexible solar cell are several orders of magnitude higher than those of other kinds of cells. The present invention has good flexibility, thus can be crimped, cut out and pasted freely. During preparation, the material and structure of the P layer are changed, and the InₓGa₁₋ₓN adjustable bandgap quantum well crystal film is introduced and used as the P-doped layer; since the InₓGa₁₋ₓN material has good stability, corrosion resistance, tunneling potential barrier and low optical loss coefficient, the conversion efficiency of the cell is increased. In the present invention, the GZO transparent conductive film used as a transparent conducting electrode is added between the Al back electrode and the N-type nc-Si:H film, wherein the GZO transparent conductive film is used as both a buffer layer and a transparent conducting electrode, which increases the transmittance of the thin film solar cell and improves the corrosion resistance of the transparent electrode, thus the photoelectric conversion efficiency of the thin film solar cell is greatly increased. In the present invention, AlN is used as the insulating layer, the lattice mismatch ratio of AlN is small, and the Al back electrode with uniform quality can be prepared.

In conclusion, the flexible solar cell of the present invention has excellent flexibility and light weight, is easy to carry, and has industrial potential and market space. Besides, the preparation process of the solar cell of the present invention is simple, which enables the solar cell to be produced in large scale.

### Description of Figures

Figure 1 is the structure diagram of the solar cell with a stainless steel substrate of an adjustable bandgap quantum well structure of the present invention.
Figure 2 is the flow chart for preparing the solar cell with a stainless steel substrate of an adjustable bandgap quantum well structure of the present invention.
Figure 3 is the X-ray Photoelectron Spectroscopy (XPS) analysis chart of the N-type nc-Si:H film in Embodiment 1 of the present invention.
Figure 4 is the Raman line of the N-type nc-Si:H film in Embodiment 1 of the present invention.
Figure 5 is the Atomic Force Microscopy (AFM) image of the N-type nc-Si:H film in Embodiment 1 of the present invention.
Figure 6 is the Raman line of the I layer nc-Si:H film in Embodiment 1 of the present invention.
Figure 7 is the XRD spectral line of the I layer nc-Si:H film in Embodiment 1 of the present invention.
Figure 8 is the AFM image of the P-type InxGa1-xN quantum well crystal film in Embodiment 1 of the present invention.

### Detailed Description

The embodiments and example of the present invention are described in detail as follows: The crystallization property test of the sample of the present invention is X-ray diffraction analysis during which an instrument of Bruker AXS D8 type is used.

In the present invention, a RENISHAW in Via Raman Microscope spectrometer is used to test the Raman spectrum of the deposited film, the laser source is a 632.8 nm Ne-He laser, the laser power is 35 mW and the resolution is 2 µm.

In the present invention, a multifunctional surface analysis system ESCALAB250 produced by the American Thermo VG is used during XPS analysis, and the X-ray source is a target Al Kα (1486.6eV) ray.

The AFM used in the present invention is Picoscan 2500 produced by Agilent. The morphology of a film sample is tested and analyzed at normal room temperature. The analyzed area of the film sample is {P1}.

### Embodiment 1

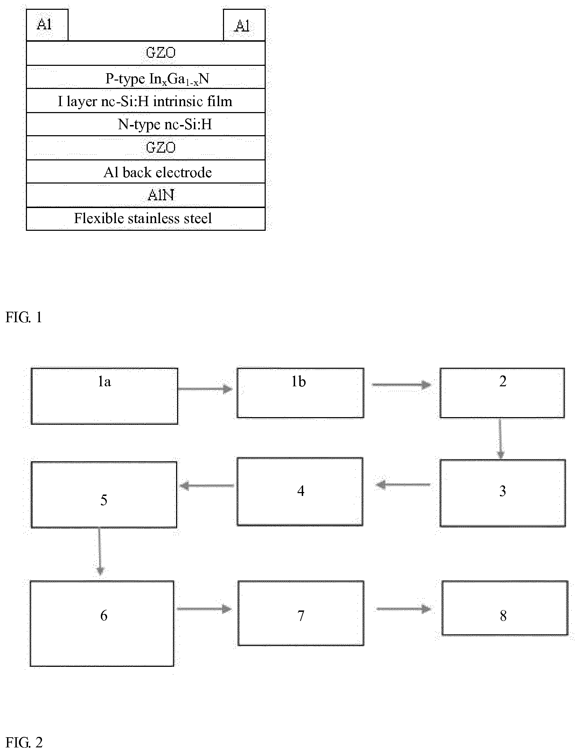

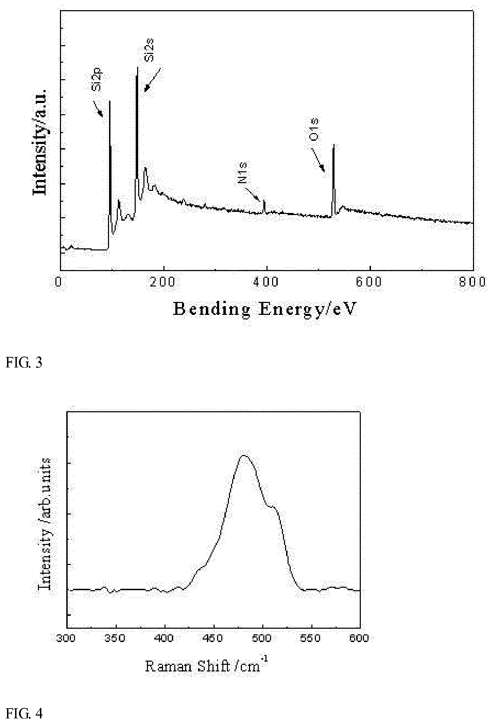

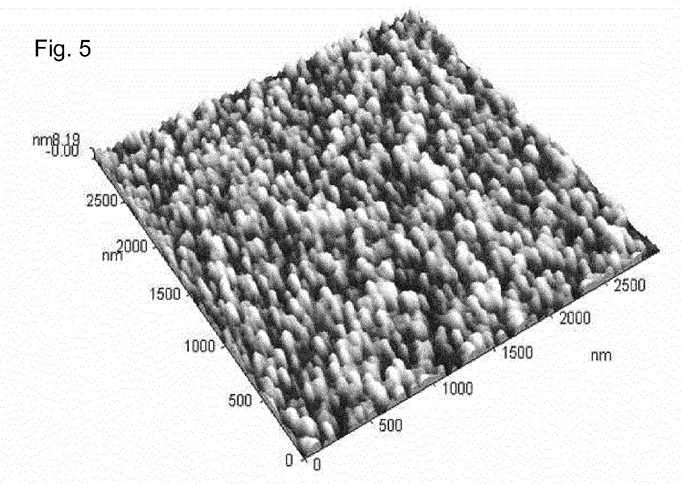

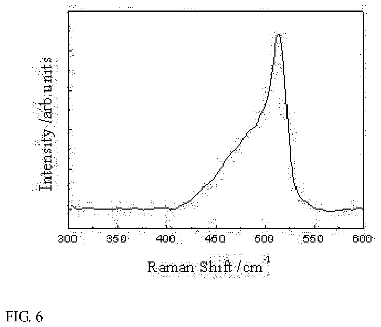

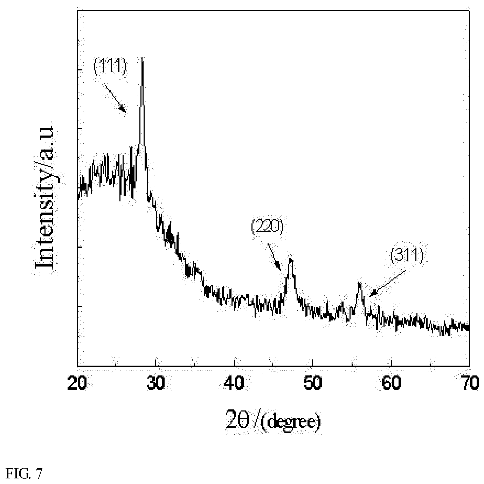

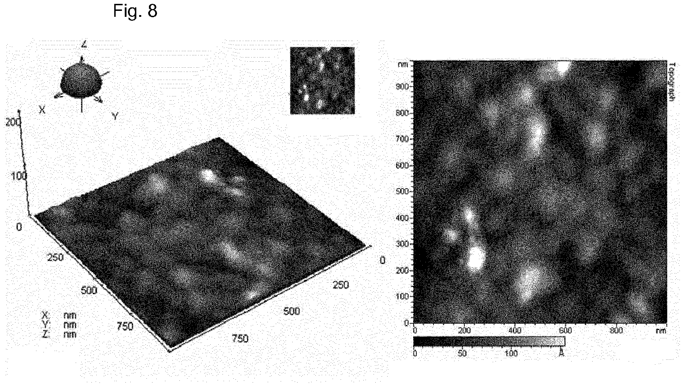

The structure diagram of the solar cell with a stainless steel substrate of an adjustable bandgap quantum well structure of this embodiment is shown in Figure 1. The preparation method comprises the steps of:
(1) After ultrasonic cleaning (1a) by ionized water for 5 min, drying up the flexible stainless steel substrate by N₂ and putting the substrate into a magnetron sputtering reaction chamber to prepare (1 b) the AlN insulating layer by deposition at a vacuum of 9.0 × 10⁻⁴ Pa; the process parameters are as follows: the reaction source is the gas mixture of Ar and N2, the flow ratio of Ar:N₂ is 10:1, the substrate is heated to 100°C, and the deposition time is 30 min. The structure at this time is AlN insulating layer/flexible stainless steel substrate.
(2) Preparing the Al metal back electrode by magnetron sputtering; the process parameters are as follows: the reaction source is Ar, the flow rate of Ar is 10 sccm, the temperature of the substrate is 50°C, and the deposition time is 3 min. The structure at this time is Al back electrode/AIN insulating layer/flexible stainless steel substrate.
(3) Preparing one GZO transparent conductive film by the ECR-PEMOCVD system; the process parameters are as follows: Ar carried TMGa, DEZn and O₂ are introduced to the reaction chamber, the flow ratio of TMGa:DEZn:O₂ is 1:2:80, the microwave power is 650 W, the deposition temperature is 200°C, the deposition pressure is 0.8 Pa, and the deposition time is 10 min. The structure at this time is GZO/Al back electrode/AIN insulating layer/flexible stainless steel substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 5 sccm, the flow rate of H₂ diluted PH₃ is 0.5 sccm, the flow rate of H₂ is 25 sccm, the microwave power is 650 W, the deposition temperature is 250°C, the deposition pressure is 0.8 Pa, and the deposition time is 30 min. The structure at this time is N-type nc-Si:H/GZO/Al back electrode/AIN insulating layer/flexible stainless steel substrate.
   The performance of the P-doped N-type nc-Si:H film is tested and analyzed by an XPS analysis equipment, and the result is shown in Figure 3. As can be seen from Figure 3, the performance of the P-doped N-type nc-Si:H film is good. The structural performance of the P-doped N-type nc-Si:H film is tested and analyzed by a Raman spectrometer, and the result is shown in Figure 4. As can be seen from Figure 4, the structural performance of the P-doped N-type nc-Si:H film is good. The morphology of the P-doped N-type nc-Si:H film is tested and analyzed by an AFM, and the result is shown in Figure 5. As can be seen from Figure 5, the morphology of the P-doped N-type nc-Si:H film is flat, and the distribution of crystal grains is uniform.
(5) Preparing the I layer nc-Si:H intrinsic film by the ECR-PEMOCVD system and introducing Ar diluted SiH₄ and H₂ to the reaction chamber; the process parameters are as follows: the flow rate of Ar diluted SiH₄ is 5 sccm, the flow rate of H₂ is 25 sccm, the microwave power is 650 W, the deposition temperature is 250°C, the deposition pressure is 0.8 Pa, and the deposition time is 30 min. The structure at this time is I layer nc-Si:H intrinsic film/N-type nc-Si:H/GZO/Al back electrode/AIN insulating layer/flexible stainless steel substrate.
   The structural performance of the non-doped I layer nc-Si:H intrinsic film is tested and analyzed by a Raman spectrometer, and the result is shown in Figure 6. As can be seen from Figure 6, the structural performance of the non-doped I layer nc-Si:H intrinsic film is good. The crystallization property of the non-doped I layer nc-Si:H intrinsic film is tested and analyzed by a XRD spectral line, and the result is shown in Figure 7. As can be seen from Figure 7, the crystallization property of the non-doped I layer nc-Si:H intrinsic film is good.
(6) Preparing the P-type InₓGa₁₋ₓN adjustable bandgap quantum well crystal film by the ECR-PEMOCVD system and introducing H₂ diluted TMGa, TMIn, Mg(C₅H₅)₂ and N₂ to the reaction chamber; the process parameters are as follows: the flow ratio of TMGa:TMIn:Mg(C₅H₅)₂ is 8:4:1, the flow rate of N₂ is 80 sccm, the microwave power is 650 W, the deposition temperature is 200°C, the deposition pressure is 0.9 Pa, and the deposition time is 40 min. The structure at this time is P-type InₓGa₁₋ₓN/I layer nc-Si:H intrinsic film/N-type nc-Si:H/GZO/Al back electrode/AIN insulating layer/flexible stainless steel substrate.
   The morphology of the Mg-doped P-type InₓGa₁₋ₓN quantum well crystal film is tested and analyzed by an AFM, and the result is shown in Figure 8. As can be seen from
   Figure 8, the morphology of the InₓGa₁₋ₓN quantum well intrinsic crystal film is flat, and the distribution of crystal grains is uniform.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the microwave power is 650 W, the deposition temperature is 200°C, the deposition pressure is 0.8 Pa, and the deposition time is 10 min. The structure at this time is GZO/P-type InₓGa₁₋ₓN/I layer nc-Si:H intrinsic film/N-type nc-Si:H/GZO/Al back electrode/AIN insulating layer/flexible stainless steel substrate.
(8) Preparing the Al metal back electrode by magnetron sputtering; the process parameters are as follows: the reaction source is Ar, the flow rate of Ar is 10 sccm, the deposition temperature is 50°C, and the deposition time is 3 min. The structure at this time is Al electrode/GZO/P-type InₓGa₁₋ₓN/I layer nc-Si:H intrinsic film/N-type nc-Si:H/GZO/Al back electrode/AIN insulating layer/flexible stainless steel substrate.

### Embodiment 2

The structure diagram of the solar cell with a stainless steel substrate of an adjustable bandgap quantum well structure of this embodiment is shown in Figure 1. The preparation method comprises the steps of:
(1) After ultrasonic cleaning (1a) by ionized water for 5 min, drying up the flexible stainless steel substrate by N₂ and putting the substrate into a magnetron sputtering reaction chamber to prepare (1 b) the AlN insulating layer by deposition at a vacuum of 9.0 × 10-4 Pa; the process parameters are as follows: the reaction source is the gas mixture of Ar and N₂, the flow ratio of Ar:N₂ is 10:1, the substrate is heated to 150°C, and the deposition time is 45 min. The structure at this time is AlN insulating layer/flexible stainless steel substrate.
(2) Preparing the Al metal back electrode by magnetron sputtering; the process parameters are as follows: the reaction source is Ar, the flow rate of Ar is 12 sccm, the temperature of the substrate is 150°C, and the deposition time is 5 min. The structure at this time is Al back electrode/AIN insulating layer/flexible stainless steel substrate.
(3) Preparing one GZO transparent conductive film by the ECR-PEMOCVD system; the process parameters are as follows: Ar carried TMGa, DEZn and O₂ are introduced to the reaction chamber, the flow ratio of TMGa:DEZn:O₂ is 1:2:80, the microwave power is 650 W, the deposition temperature is 250°C, the deposition pressure is 1.0 Pa, and the deposition time is 13 min. The structure at this time is GZO/Al back electrode/AIN insulating layer/flexible stainless steel substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 6 sccm, the flow rate of H₂ diluted PH₃ is 3 sccm, the flow rate of H₂ is 28 sccm, the microwave power is 650 W, the deposition temperature is 300°C, the deposition pressure is 1.0 Pa, and the deposition time is 40 min. The structure at this time is N-type nc-Si:H/GZO/Al back electrode/AIN insulating layer/flexible stainless steel substrate.
(5) Preparing the I layer nc-Si:H intrinsic film by the ECR-PEMOCVD system and introducing Ar diluted SiH₄ and H₂ to the reaction chamber; the process parameters are as follows: the flow rate of Ar diluted SiH₄ is 6 sccm, the flow rate of H₂ is 26 sccm, the microwave power is 650 W, the deposition temperature is 300°C, the deposition pressure is 1.0 Pa, and the deposition time is 48 min. The structure at this time is I layer nc-Si:H intrinsic film/N-type nc-Si:H/GZO/Al back electrode/AIN insulating layer/flexible stainless steel substrate.
(6) Preparing the P-type InₓGa₁₋ₓN adjustable bandgap quantum well crystal film by the ECR-PEMOCVD system and introducing H₂ diluted TMGa, TMIn, Mg(C₅H₅)₂ and N₂ to the reaction chamber; the process parameters are as follows: the flow ratio of TMGa:TMIn:Mg(C₅H₅)₂ is 8:4:1, the flow rate of N₂ is 105 sccm, the microwave power is 650 W, the deposition temperature is 600°C, the deposition pressure is 1.0 Pa, and the deposition time is 50 min. The structure at this time is P-type InₓGa₁₋ₓN/I layer nc-Si:H intrinsic film/N-type nc-Si:H/GZO/Al back electrode/AIN insulating layer/flexible stainless steel substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the microwave power is 650 W, the deposition temperature is 400°C, the deposition pressure is 1.0 Pa, and the deposition time is 18 min. The structure at this time is GZO/P-type InₓGa₁₋ₓN/I layer nc-Si:H intrinsic film/N-type nc-Si:H/GZO/Al back electrode/AIN insulating layer/flexible stainless steel substrate.
(8) Preparing the Al metal back electrode by magnetron sputtering; the process parameters are as follows: the reaction source is Ar, the flow rate of Ar is 18 sccm, the deposition temperature is 150°C, and the deposition time is 10 min. The structure at this time is Al electrode/GZO/P-type InₓGa₁₋ₓN/I layer nc-Si:H intrinsic film/N-type nc-Si:H/GZO/Al back electrode/AIN insulating layer/flexible stainless steel substrate.

### Example 1

The structure diagram of the solar cell with a stainless steel substrate of an adjustable bandgap quantum well structure of this example is shown in Figure 1. The preparation method comprises the steps of:
(1) After ultrasonic cleaning (1a) by ionized water for 5 min, drying up the flexible stainless steel substrate by N₂ and putting the substrate into a magnetron sputtering reaction chamber to prepare (1 b) the AlN insulating layer by deposition at a vacuum of 9.0 × 10⁻⁴ Pa; the process parameters are as follows: the reaction source is the gas mixture of Ar and N₂, the flow ratio of Ar:N₂ is 10:1, the substrate is heated to 300°C, and the deposition time is 60 min. The structure at this time is AlN insulating layer/flexible stainless steel substrate.
(2) Preparing the Al metal back electrode by magnetron sputtering; the process parameters are as follows: the reaction source is Ar, the flow rate of Ar is 20 sccm, the temperature of the substrate is 350°C, and the deposition time is 10 min. The structure at this time is Al back electrode/AIN insulating layer/flexible stainless steel substrate.
(3) Preparing one GZO transparent conductive film by the ECR-PEMOCVD system; the process parameters are as follows: Ar carried TMGa, DEZn and O₂ are introduced to the reaction chamber, the flow ratio of TMGa:DEZn:O₂ is 1:2:80, the microwave power is 650 W, the deposition temperature is 400°C, the deposition pressure is 1.2 Pa, and the deposition time is 20 min. The structure at this time is GZO/Al back electrode/AIN insulating layer/flexible stainless steel substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 8 sccm, the flow rate of H₂ diluted PH₃ is 5 sccm, the flow rate of H₂ is 40 sccm, the microwave power is 650 W, the deposition temperature is 600°C, the deposition pressure is 1.2 Pa, and the deposition time is 80 min. The structure at this time is N-type nc-Si:H/GZO/Al back electrode/AIN insulating layer/flexible stainless steel substrate.
(5) Preparing the I layer nc-Si:H intrinsic film by the ECR-PEMOCVD system and introducing Ar diluted SiH₄ and H₂ to the reaction chamber; the process parameters are as follows: the flow rate of Ar diluted SiH₄ is 8 sccm, the flow rate of H₂ is 40 sccm, the microwave power is 650 W, the deposition temperature is 600°C, the deposition pressure is 1.8 Pa, and the deposition time is 80 min. The structure at this time is I layer nc-Si:H intrinsic film/N-type nc-Si:H/GZO/Al back electrode/AIN insulating layer/flexible stainless steel substrate.
(6) Preparing the P-type InxGa1-xN adjustable bandgap quantum well crystal film by the ECR-PEMOCVD system and introducing H₂ diluted TMGa, TMIn, Mg(C₅H₅)₂ and N₂ to the reaction chamber; the process parameters are as follows: the flow ratio of TMGa:TMIn:Mg(C₅H₅)₂ is 8:4:1, the flow rate of N₂ is 120 sccm, the microwave power is 650 W, the deposition temperature is 300°C, the deposition pressure is 1.4 Pa, and the deposition time is 60 min. The structure at this time is P-type InₓGa₁₋ₓN/I layer nc-Si:H intrinsic film/N-type nc-Si:H/GZO/Al back electrode/AIN insulating layer/flexible stainless steel substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the microwave power is 650 W, the deposition temperature is 300°C, the deposition pressure is 1.2 Pa, and the deposition time is 20 min. The structure at this time is GZO/P-type InₓGa₁₋ₓN/I layer nc-Si:H intrinsic film/N-type nc-Si:H/GZO/Al back electrode/AlN insulating layer/flexible stainless steel substrate.
(8) Preparing the Al metal back electrode by magnetron sputtering; the process parameters are as follows: the reaction source is Ar, the flow rate of Ar is 20 sccm, the deposition temperature is 400°C, and the deposition time is 5 min. The structure at this time is Al electrode/GZO/P-type InₓGa₁₋ₓN/I layer nc-Si:H intrinsic film/N-type nc-Si:H/GZO/Al back electrode/AlN insulating layer/flexible stainless steel substrate.

### Embodiment 3

The structure diagram of the solar cell with a stainless steel substrate of an adjustable bandgap quantum well structure of this embodiment is shown in Figure 1. The preparation method comprises the steps of:
(1) After ultrasonic cleaning (1a) by ionized water for 5 min, drying up the flexible stainless steel substrate by N₂ and putting the substrate into a magnetron sputtering reaction chamber to prepare (1 b) the AlN insulating layer by deposition at a vacuum of 9.0 × 10⁻⁴ Pa; the process parameters are as follows: the reaction source is the gas mixture of Ar and N₂, the flow ratio of Ar:N₂ is 10:1, the substrate is heated to 250°C, and the deposition time is 50 min. The structure at this time is AlN insulating layer/flexible stainless steel substrate.
(2) Preparing the Al metal back electrode by magnetron sputtering; the process parameters are as follows: the reaction source is Ar, the flow rate of Ar is 18 sccm, the temperature of the substrate is 280°C, and the deposition time is 9 min. The structure at this time is Al back electrode/AIN insulating layer/flexible stainless steel substrate.
(3) Preparing one GZO transparent conductive film by the ECR-PEMOCVD system; the process parameters are as follows: Ar carried TMGa, DEZn and O₂ are introduced to the reaction chamber, the flow ratio of TMGa:DEZn:O₂ is 1:2:80, the microwave power is 650 W, the deposition temperature is 380°C, the deposition pressure is 1.1 Pa, and the deposition time is 18 min. The structure at this time is GZO/Al back electrode/AIN insulating layer/flexible stainless steel substrate.
(4) Preparing the N-type nc-Si:H film by the ECR-PEMOCVD system and introducing Ar diluted SiH4 and H₂ diluted PH₃ to the reaction chamber; the process parameters are as follows: the flow rate of Ar diluted SiH₄ is 7 sccm, the flow rate of H₂ diluted PH₃ is 4 sccm, the flow rate of H₂ is 35 sccm, the microwave power is 650 W, the deposition temperature is 550°C, the deposition pressure is 1.1 Pa, and the deposition time is 70 min. The structure at this time is N-type nc-Si:H/GZO/Al back electrode/AIN insulating layer/flexible stainless steel substrate.
(5) Preparing the I layer nc-Si:H intrinsic film by the ECR-PEMOCVD system and introducing Ar diluted SiH₄ and H₂ to the reaction chamber; the process parameters are as follows: the flow rate of Ar diluted SiH₄ is 7 sccm, the flow rate of H₂ is 36 sccm, the microwave power is 650 W, the deposition temperature is 500°C, the deposition pressure is 1.0 Pa, and the deposition time is 60 min. The structure at this time is I layer nc-Si:H intrinsic film/N-type nc-Si:H/GZO/Al back electrode/AIN insulating layer/flexible stainless steel substrate.
(6) Preparing the P-type InₓGa₁₋ₓN adjustable bandgap quantum well crystal film by the ECR-PEMOCVD system and introducing H₂ diluted TMGa, TMIn, Mg(C₅H₅)₂ and N₂ to the reaction chamber; the process parameters are as follows: the flow ratio of TMGa:TMIn:Mg(C₅H₅)₂ is 8:4:1, the flow rate of N₂ is 100 sccm, the microwave power is 650 W, the deposition temperature is 600°C, the deposition pressure is 1.2 Pa, and the deposition time is 50 min. The structure at this time is P-type InₓGa₁₋ₓN/I layer nc-Si:H intrinsic film/N-type nc-Si:H/GZO/Al back electrode/AIN insulating layer/flexible stainless steel substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the microwave power is 650 W, the deposition temperature is 300°C, the deposition pressure is 1.1 Pa, and the deposition time is 15 min. The structure at this time is GZO/P-type InₓGa₁₋ₓN/I layer nc-Si:H intrinsic film/N-type nc-Si:H/GZO/Al back electrode/AlN insulating layer/flexible stainless steel substrate.
(8) Preparing the Al metal back electrode by magnetron sputtering; the process parameters are as follows: the reaction source is Ar, the flow rate of Ar is 18 sccm, the deposition temperature is 300°C, and the deposition time is 8 min. The structure at this time is Al electrode/GZO/P-type InₓGa₁₋ₓN/I layer nc-Si:H intrinsic film/N-type nc-Si:H/GZO/Al back electrode/AlN insulating layer/flexible stainless steel substrate.

### Embodiment 4

The structure diagram of the solar cell with a stainless steel substrate of an adjustable bandgap quantum well structure of this embodiment is shown in Figure 1. The preparation method comprises the steps of:
(1) After ultrasonic cleaning (1a) by ionized water for 5 min, drying up the flexible stainless steel substrate by N₂ and putting the substrate into a magnetron sputtering reaction chamber to prepare (1b) the AlN insulating layer by deposition at a vacuum of 9.0 × 10⁻⁴ Pa; the process parameters are as follows: the reaction source is the gas mixture of Ar and N₂, the flow ratio of Ar:N₂ is 10:1, the substrate is heated to 230°C, and the deposition time is 60 min. The structure at this time is AlN insulating layer/flexible stainless steel substrate.
(2) Preparing the Al metal back electrode by magnetron sputtering; the process parameters are as follows: the reaction source is Ar, the flow rate of Ar is 15 sccm, the temperature of the substrate is 300°C, and the deposition time is 10 min. The structure at this time is Al back electrode/AlN insulating layer/flexible stainless steel substrate.
(3) Preparing one GZO transparent conductive film by the ECR-PEMOCVD system; the process parameters are as follows: Ar carried TMGa, DEZn and O₂ are introduced to the reaction chamber, the flow ratio of TMGa:DEZn:O₂ is 1:2:80, the microwave power is 650 W, the deposition temperature is 400°C, the deposition pressure is 1.1 Pa, and the deposition time is 20 min. The structure at this time is GZO/Al back electrode/AIN insulating layer/flexible stainless steel substrate.
(4) Preparing the N-type nc-Si:H film by the ECR-PEMOCVD system and introducing Ar diluted SiH₄ and H₂ diluted PH₃ to the reaction chamber; the process parameters are as follows: the flow rate of Ar diluted SiH₄ is 8 sccm, the flow rate of H₂ diluted PH₃ is 5 sccm, the flow rate of H₂ is 35 sccm, the microwave power is 650 W, the deposition temperature is 500°C, the deposition pressure is 1.1 Pa, and the deposition time is 75 min. The structure at this time is N-type nc-Si:H/GZO/Al back electrode/AIN insulating layer/flexible stainless steel substrate.
(5) Preparing the I layer nc-Si:H intrinsic film by the ECR-PEMOCVD system and introducing Ar diluted SiH₄ and H₂ to the reaction chamber; the process parameters are as follows: the flow rate of Ar diluted SiH₄ is 7 sccm, the flow rate of H₂ is 40 sccm, the microwave power is 650 W, the deposition temperature is 600°C, the deposition pressure is 0.8 Pa, and the deposition time is 70 min. The structure at this time is I layer nc-Si:H intrinsic film/N-type nc-Si:H/GZO/Al back electrode/AIN insulating layer/flexible stainless steel substrate.
(6) Preparing the P-type InₓGa₁₋ₓN adjustable bandgap quantum well crystal film by the ECR-PEMOCVD system and introducing H₂ diluted TMGa, TMIn, Mg(C₅H₅)₂ and N₂ to the reaction chamber; the process parameters are as follows: the flow ratio of TMGa:TMIn:Mg(C₅H₅)₂ is 8:4:1, the flow rate of N₂ is 110 sccm, the microwave power is 650 W, the deposition temperature is 600°C, the deposition pressure is 1.2 Pa, and the deposition time is 60 min. The structure at this time is P-type InₓGa₁₋ₓN/I layer nc-Si:H intrinsic film/N-type nc-Si:H/GZO/Al back electrode/AIN insulating layer/flexible stainless steel substrate.
(7) Preparing the other GZO transparent conductive film by the ECR-PEMOCVD system and introducing Ar carried TMGa, DEZn and O₂ to the reaction chamber; the process parameters are as follows: the flow ratio of TMGa:DEZn:O₂ is 1:2:80, the microwave power is 650 W, the deposition temperature is 300°C, the deposition pressure is 1.2 Pa, and the deposition time is 20 min. The structure at this time is GZO/P-type InₓGa₁₋ₓN/I layer nc-Si:H intrinsic film/N-type nc-Si:H/GZO/Al back electrode/AIN insulating layer/flexible stainless steel substrate.
(8) Preparing the Al metal back electrode by magnetron sputtering; the process parameters are as follows: the reaction source is Ar, the flow rate of Ar is 20 sccm, the deposition temperature is 300°C, and the deposition time is 8 min. The structure at this time is Al electrode/GZO/P-type InₓGa₁₋ₓN/I layer nc-Si:H intrinsic film/N-type nc-Si:H/GZO/Al back electrode/AlN insulating layer/flexible stainless steel substrate.

## Claims

1. A preparation method for the solar cell with a stainless steel substrate of an adjustable bandgap quantum well structure , wherein a stainless steel sheet is used as a flexible substrate, an AlN insulating layer is above the substrate, an Al back electrode is above the AlN insulating layer, a Ga-doped ZnO (GZO) transparent conductive film used as a buffer layer is above the Al back electrode, an N-type hydrogenated nano-crystalline silicon (nc-Si:H) film is above the GZO transparent conductive film, an I layer nc-Si:H intrinsic film is above the N-type nc-Si:H film, a P-type InₓGa₁₋ₓN film is above the I layer nc-Si:H intrinsic film, another GZO transparent conductive film is above the P-type InₓGa₁₋ₓN film, and an Al metal electrode is above the GZO transparent conductive film, the specific structure being Al electrode/GZO/P-type InₓGa₁₋ₓN/I layer nc-Si:H film/N-type nc-Si:H/GZO/Al back electrode/AIN insulating layer/flexible stainless steel substrate, wherein the P-type InₓGa₁₋ₓN film has an adjustable bandgap width and a quantum well structure, wherein the value of x in the P-type film comprising InₓGa₁₋ₓN is between 0 and 1, **characterized in that** it comprises the steps of:
(1) After ultrasonic cleaning by ionized water, drying up the flexible stainless steel substrate by N₂ and putting the substrate into a magnetron sputtering reaction chamber to prepare the AlN insulating layer by deposition at a vacuum of 9.0 × 10⁻⁴ Pa; the process parameters being as follows: the target material is aluminum, the reaction source is the gas mixture of Ar and N₂, the flow ratio of Ar:N₂ is 10:1, the substrate is heated to 100 to 300°C, and the deposition time is 30 to 60 min, the structure at this time being AlN insulating layer/flexible stainless steel substrate;
(2) Preparing the Al metal back electrode by magnetron sputtering; the process parameters being as follows: the reaction source is Ar, the flow rate of Ar is 10 to 20 sccm, the target material is aluminum, the temperature of the substrate is 50 to 350°C, and the deposition time is 3 to 10 min, the structure at this time being Al back electrode/AIN insulating layer/flexible stainless steel substrate;
(3) Preparing one GZO transparent conductive film by an Electron Cyclotron Resonance Plasma Enhanced Chemical Vapor Deposition (ECR-PEMOCVD) system; the process parameters being as follows: Ar carried trimethyl gallium (TMGa), diethyl zinc (DEZn) and O₂ are introduced to the reaction chamber, the flow ratio of TMGa:DEZn:O₂ is 1:2:80, the microwave power is 650 W, the deposition temperature is 200 to 400°C, the deposition pressure is 0.8 to 1.2 Pa, and the deposition time is 10 to 20 min, the structure at this time being GZO/Al back electrode/AIN insulating layer/flexible stainless steel substrate;
(4) Preparing the N-type nc-Si:H film by the ECR-PEMOCVD system and introducing Ar diluted SiH₄ and H₂ diluted PH₃ to the reaction chamber; the process parameters being as follows: the flow rate of Ar diluted SiH₄ is 5 to 8 sccm, the flow rate of H₂ diluted PH₃ is 0.5 to 5 sccm, the flow rate of H₂ is 25 to 40 sccm, the microwave power is 650 W, the deposition temperature is 250 to 600°C, the deposition pressure is 0.8 to 1.2 Pa, and the deposition time is 30 to 80 min, the structure at this time being N-type nc-Si:H/GZO/Al back electrode/AIN insulating layer/flexible stainless steel substrate;
(5) Preparing the I layer nc-Si:H intrinsic film by the ECR-PEMOCVD system and introducing Ar diluted SiH₄ and H₂ to the reaction chamber; the process parameters being as follows: the flow rate of Ar diluted SiH₄ is 5 to 8 sccm, the flow rate of H₂ is 25 to 40 sccm, the microwave power is 650 W, the deposition temperature is 250 to 600°C, the deposition pressure is 0.8 to 1.2 Pa, and the deposition time is 30 to 80 min, the structure at this time being I layer nc-Si:H intrinsic film/N-type nc-Si:H/GZO/Al back electrode/AIN insulating layer/flexible stainless steel substrate.
(6) Preparing the P-type InₓGa₁₋ₓN film by the ECR-PEMOCVD system and introducing H₂ diluted trimethyl gallium (TMGa), trimethyl indium (TMIn), ferrocene magnesium (Mg(C₅H₅)₂) and N₂ to the reaction chamber; the process parameters being as follows: the flow ratio of TMGa:TMIn:Mg(C₅H₅)₂ is 8:4:1, the flow rate of N₂ is 80 to 120 sccm, the microwave power is 650 W, the deposition temperature is 200 to 600°C, the deposition pressure is 0.9 to 1.4 Pa, and the deposition time is 40 to 60 min, the structure at this time being P-type InₓGa₁₋ₓN/I layer nc-Si:H intrinsic film/N-type nc-Si:H/GZO/Al back electrode/AIN insulating layer/flexible stainless steel substrate;
(7) Preparing the other GZO transparent conductive film by the ECR-PEMOCVD system and introducing Ar carried TMGa, DEZn and O₂ to the reaction chamber; the process parameters being as follows: the flow ratio of TMGa:DEZn:O₂ is 1:2:80, the microwave power is 650 W, the deposition temperature is 200 to 400°C, the deposition pressure is 0.8 to 1.2 Pa, and the deposition time is 10 to 20 min, the structure at this time being GZO/P-type InₓGa₁₋ₓN/I layer nc-Si:H intrinsic film/N-type nc-Si:H/GZO/Al back electrode/AIN insulating layer/flexible stainless steel substrate;
(8) Preparing the Al metal back electrode by magnetron sputtering; the process parameters being as follows: the reaction source is Ar, the flow rate of Ar is 10 to 20 sccm, the target material is aluminum, the deposition temperature is 50 to 400°C, and the deposition time is 3 to 10 min, the structure at this time being Al electrode/GZO/P-type InₓGa₁₋ₓN/I layer nc-Si:H intrinsic film/N-type nc-Si:H/GZO/Al back electrode/AIN insulating layer/flexible stainless steel substrate.

2. The preparation method for the solar cell with a stainless steel substrate of an adjustable bandgap quantum well structure of Claim 1, **characterized in that** the target material of aluminum used during magnetron sputtering has a purity of 99.99%.

## Patentansprüche

1. Verfahren zum Herstellen der Solarzelle mit einem Edelstahlsubstrat mit einer Quantentopfstruktur mit einstellbarer Bandlücke, wobei ein Edelstahlblech als flexibles Substrat verwendet wird, eine AlN-Isolierschicht über dem Substrat ist, eine Al-Rückelektrode über der AlN-Isolierschicht ist, ein transparenter leitfähiger Film aus Ga-dotiertem ZnO (GZO), der als Pufferschicht verwendet wird, über der Al-Rückelektrode ist, ein Film aus hydriertem nanokristallinem Silicium (nc-Si:H) vom N-Typ über dem transparenten leitfähigen GZO-Film ist, ein intrinsischer I-Schicht-nc-Si:H-Film über dem N-Typ-nc-Si:H-Film ist, ein P-Typ-InₓGa₁₋ₓN-Film über dem intrinsischen I-Schicht-nc-Si:H-Film ist, ein weiterer transparenter leitfähiger GZO-film über dem P-Typ-InₓGa₁₋ₓN-Film ist und eine Al-Metallelektrode über dem transparenten leitfähigen GZO-Film ist, wobei die spezifische Struktur Al-Elektrode/GZO/P-Typ-InₓGa₁₋ₓN/I-Schicht-nc-Si-H:Film/N-Typ-nc-Si:H/GZO/Al-Rückelektrode/AlN-Isolierschicht/flexibles Edelstahlsubstrat ist, wobei der P-Typ-InₓGa₁₋ₓN-Film eine einstellbare Bandlückenbreite und eine Quantentopfstruktur aufweist, wobei der Wert x im P-Typ-Film, der InₓGa₁₋ₓN umfasst, zwischen 0 und 1 liegt, **dadurch gekennzeichnet, dass** es die Schritte umfasst:
(1) Nach Ultraschallreinigen mit ionisiertem Wasser Austrocknen des flexiblen Edelstahlsubstrats mit N₂ und Platzieren des Substrats in einer Magnetronsputterreaktionskammer zur Herstellung der AlN-Isolierschicht durch Abscheiden unter einem Vakuum von 9,0 x 10⁻⁴ Pa; wobei die Prozessparameter wie folgt sind: Das Zielmaterial ist Aluminium, die Reaktionsquelle ist die Gasmischung von Ar und N₂, das Durchflussverhältnis von Ar:N₂ beträgt 10:1, das Substrat wird auf 100 bis 300 °C erhitzt und die Abscheidungszeit beträgt 30 bis 60 min, wobei die Struktur dieses Mal AlN-Isolierschicht/flexibles Edelstahlsubstrat ist;
(2) Herstellen der Al-Metallrückelektrode durch Magnetronsputtern; wobei die Prozessparameter wie folgt sind: Die Reaktionsquelle ist Ar, die Durchflussrate von Ar beträgt 10 bis 20 sccm, das Zielmaterial ist Aluminium, die Temperatur des Substrats beträgt 50 bis 350 °C und die Abscheidungszeit beträgt 3 bis 10 min, wobei die Struktur dieses Mal Al-Rückelektrode/AlN-Isolierschicht/flexibles Edelstahlsubstrat ist;
(3) Herstellen eines transparenten leitfähigen GZO-Films durch ein Elektronen-Zyklotron-Resonanz-Plasmaunterstützte-Chemische-Gasphasenabscheidung-(ECR-PEMOCVD)-System, wobei die Prozessparameter wie folgt sind: Ar-getragenes Trimethylgallium (TMGa), Diethylzink (DEZn) und O₂ werden in die Reaktionskammer eingebracht, das Durchflussverhältnis von TMGa:DEZn:O₂ beträgt 1:2:80, die Mikrowellenleistung beträgt 650 W, die Abscheidungstemperatur beträgt 200 bis 400 °C, der Abscheidungsdruck beträgt 0,8 bis 1,2 Pa und die Abscheidungszeit beträgt 10 bis 20 min, wobei die Struktur dieses Mal GZO/Al-Rückelektrode/AlN-Isolierschicht/flexibles Edelstahlsubstrat ist;
(4) Herstellen des N-Typ-nc-Si:H-Films durch das ECR-PEMOCVD-System und Einbringen von Ar-verdünntem SiH₄ und H₂-verdünntem PH₃ in die Reaktionskammer; wobei die Prozessparameter wie folgt sind: Die Durchflussrate von Ar-verdünntem SiH₄ beträgt 5 bis 8 sccm, die Durchflussrate von H₂-verdünntem PH₃ beträgt 0,5 bis 5 sccm, die Durchflussrate von H₂ beträgt 25 bis 40 sccm, die Mikrowellenleistung beträgt 650 W, die Abscheidungstemperatur beträgt 250 bis 600 °C, die Mikrowellenleistung beträgt 650 W, der Abscheidungsdruck beträgt 0,8 bis 1,2 Pa und die Abscheidungszeit beträgt 30 bis 80 min, wobei die Struktur dieses Mal N-Typ-nc-Si:H/GZO/Al-Rückelektrode/AlN-Isolierschicht/flexibles Edelstahlsubstrat ist;
(5) Herstellen des intrinsischen I-Schicht-nc-Si:H-Films durch das ECR-PEMOCVD-System und Einbringen von Ar-verdünntem SiH₄ und H₂ in die Reaktionskammer; wobei die Prozessparameter wie folgt sind: Die Durchflussrate von Ar-verdünntem SiH₄ beträgt 5 bis 8 sccm, die Durchflussrate von H₂ beträgt 25 bis 40 sccm, die Mikrowellenleistung beträgt 650 W, die Abscheidungstemperatur beträgt 250 bis 350 °C, die Mikrowellenleistung beträgt 650 W, die Abscheidungstemperatur beträgt 250 bis 600 °C, der Abscheidungsdruck beträgt 0,8 bis 1,2 Pa und die Abscheidungszeit beträgt 30 bis 80 min, wobei die Struktur dieses Mal intrinsischer I-Schicht-nc-Si:H-Film/N-Typ-nc-Si:H/GZO/Al-Rückelektrode/AlN-Isolierschicht/flexibles Edelstahlsubstrat ist.
(6) Herstellen des P-Typ-InₓGa₁₋ₓN-Films durch das ECR-PEMOCVD-System und Einbringen von H₂-verdünntem Trimethylgallium (TMGa), Trimethylindium (TMIn), Ferrocenmagnesium (Mg(CH₅H₅)₂) und N₂ in die Reaktionskammer; wobei die Prozessparameter wie folgt sind: Das Durchflussverhältnis von TMGa:TMIn:Mg(C₅H₅)₂) beträgt 8:4:1, die Durchflussrate von N₂ beträgt 80 bis 120 sccm, die Mikrowellenleistung beträgt 650 W, die Abscheidungstemperatur beträgt 200 bis 600 °C, der Abscheidungsdruck beträgt 0,9 bis 1,4 Pa und die Abscheidungszeit beträgt 40 bis 60 min, wobei die Struktur dieses Mal P-Typ-InₓGa₁₋ₓN/intrinsischer I-Schicht-nc-Si:H-Film/N-Typ-nc-Si:H/GZO/Al-Rückelektrode/AlN-Isolierschicht/flexibles Edelstahlsubstrat ist;
(7) Herstellen des anderen transparenten leitfähigen GZO-Films durch das ECR-PEMOCVD-System und Einbringen von Ar-getragenem TMGa, DEZn und O₂ in die Reaktionskammer; wobei die Prozessparameter wie folgt sind: Das Durchflussverhältnis von TMGa:DEZn:O₂ beträgt 1:2:80, die Mikrowellenleistung beträgt 650 W, die Abscheidungstemperatur beträgt 200 bis 400 °C, der Abscheidungsdruck beträgt 0,8 bis 1,2 Pa und die Abscheidungszeit beträgt 10 bis 20 min, wobei die Struktur dieses Mal GZO/P-Typ-InₓGa₁₋ₓN/intrinsischer I-Schicht-nc-Si:H-Film/N-Typ-nc-Si:H/GZO/Al-Rückelektrode/AlN-Isolierschicht/flexibles Edelstahlsubstrat ist;
(8) Herstellen der Al-Metallrückelektrode durch Magnetronsputtern; wobei die Prozessparameter wie folgt sind: Die Reaktionsquelle ist Ar, die Durchflussrate von Ar beträgt 10 bis 20 sccm, das Zielmaterial ist Aluminium, die Abscheidungstemperatur beträgt 50 bis 400 °C und die Abscheidungszeit beträgt 3 bis 10 min, wobei die Struktur dieses Mal Al-Elektrode/GZO/P-Typ-InₓGa₁₋ₓN/intrinsischer I-Schicht-nc-Si:H-Film/N-Typ-nc-Si:H/GZO/Al-Rückelektrode/AlN-Isolierschicht/flexibles Edelstahlsubstrat ist.

2. Verfahren zum Herstellen der Solarzelle mit einem Edelstahlsubstrat mit einer Quantentopfstruktur mit einstellbarer Bandlücke nach Anspruch 1, **dadurch gekennzeichnet, dass** das Zielmaterial von Aluminium, das während des Magnetronsputterns verwendet wird, eine Reinheit von 99,99 % aufweist.

## Revendications

1. Procédé de préparation d'une cellule photovoltaïque à substrat en inox avec une structure à puits quantique de bande interdite ajustable, dans laquelle on utilise une feuille d'acier inox comme substrat flexible, une couche isolante AIN est située au-dessus du substrat, une électrode arrière en Al est située au-dessus de la couche isolante AIN, un film conducteur transparent en ZnO dopé au Ga (GZO), utilisé comme couche tampon, est situé au-dessus de l'électrode arrière Al, un film de silicium hydrogéné nanocristallin de type N (nc-Si:H) est situé au-dessus de la couche du film conducteur transparent GZO, un film intrinsèque constitué d'une couche I de nc-Si:H est situé au-dessus du film de silicium hydrogéné nanocristallin de type N, un film de InₓGa₁₋ₓN de type P est situé au-dessus du film de couche I de nc-Si:H, un autre film conducteur transparent GZO est situé au-dessus du film de InₓGa₁₋ₓN de type P, et une électrode en Al métallique est située au-dessus du film conducteur transparent GZO, la structure spécifique étant électrode Al / GZO / InₓGa₁₋ₓN de type P / film de couche I de nc-Si:H / nc-Si:H de type N / GZO / électrode arrière Al / couche isolante AIN / substrat flexible inox, où le film intrinsèque de InₓGa₁₋ₓN de type P a une bande interdite ajustable et une structure à puits quantique, la valeur de x dans le film de type P contenant InₓGa₁₋ₓN étant entre 0 et 1, **caractérisé en ce qu'**il comprend les étapes de :
(1) Après nettoyage aux ultrasons par eau désionisée, séchage du substrat inox par N₂ et placement du substrat dans une chambre réactionnelle à pulvérisation magnétron pour préparer la couche isolante AIN par dépôt sous un vide de 9,0.10⁻⁴ Pa ; les paramètres de procédé étant comme suit : le matériau cible est l'aluminium, la source réactionnelle est le mélange gazeux d'Ar et N₂, le rapport d'écoulement Ar:N₂ est de 10:1, le substrat est chauffé à de 100 à 300°C, et la durée de dépôt est de 30 à 60 min, la structure à ce moment étant couche isolante AIN / substrat flexible inox ;
(2) Préparation de l'électrode arrière d'Al métal par pulvérisation magnétron ; les paramètres de procédé étant comme suit : la source réactionnelle est Ar, le débit d'Ar est de 10 à 20 sccm, le matériau cible est l'aluminium, la température du substrat est de 50 à 350°C, et la durée de dépôt est de 3 à 10 min, la structure à ce moment étant électrode arrière d'Al / couche isolante AIN / substrat flexible inox.
(3) Préparation d'un film conducteur transparent GZO par système de dépôt chimique en phase vapeur assistée par plasma à résonance cyclotron électronique (ECR-PEMOCVD) ; les paramètres de procédé étant comme suit : du triméthylgallium (TMGa) sous Ar, du diéthylzinc (DEZn) et O₂ sont introduits dans la chambre de réaction, le rapport d'écoulement TMGa:DEZn:O₂ est 1:2:80, la puissance des micro-ondes est 650 W, la température de dépôt est de 200 à 400°C, la pression de dépôt est de 0,8 à 1,2 Pa, et la durée de dépôt est de 10 à 20 min, la structure à ce moment étant GZO / électrode arrière d'Al / couche isolante AIN / substrat flexible inox.
(4) Préparation du film nc-Si:H de type N par système de dépôt chimique en phase vapeur assistée par plasma à résonance cyclotron électronique (ECR-PEMOCVD) et introduction de SiH₄ dilué dans Ar et PH₃ dilué dans H₂ dans la chambre de réaction ; les paramètres de procédé étant comme suit : le débit d'écoulement de SiH₄ dilué dans Ar est 5 à 8 sccm, le débit d'écoulement de PH₃ dilué dans H₂ est 0,5 à 5 sccm, le débit de H₂ est 25 à 40 sccm, la puissance des micro-ondes est 650 W, la température de dépôt est de 250 à 600°C, la pression de dépôt est de 0,8 à 1,2 Pa, et la durée de dépôt est de 30 à 80 min, la structure à ce moment étant nc-Si:H type N / GZO / électrode arrière d'Al / couche isolante AIN / substrat flexible inox.
(5) Préparation du film cristallin intrinsèque nc-Si:H couche I par système de dépôt chimique en phase vapeur assistée par plasma à résonance cyclotron électronique (ECR-PEMOCVD) et introduction de SiH₄ dilué dans Ar et H₂ dans la chambre de réaction ; les paramètres de procédé étant comme suit : le débit d'écoulement de SiH₄ dilué dans Ar est de 5 à 8 sccm, le débit d'écoulement de N₂ est de 25 à 40 sccm, la puissance des micro-ondes est 650 W, la température de dépôt est de 250 à 600°C, la pression de dépôt est de 0,8 à 1,2 Pa, et la durée de dépôt est de 30 à 80 min, la structure à ce moment étant film intrinsèque nc-Si:H / nc-Si:H type N / GZO / électrode arrière d'Al / couche isolante AIN / substrat flexible inox.
(6) Préparation du film InₓGa₁₋ₓN de type P par système de dépôt chimique en phase vapeur assistée par plasma à résonance cyclotron électronique (ECR-PEMOCVD) et introduction de triméthylgallium (TMGa) dilué dans H₂, triméthylindium (TMIn), ferrocène magnésium (Mg(C₅H₅)₂) et N₂ dans la chambre de réaction ; les paramètres de procédé étant comme suit : le rapport d'écoulement TMGa:TMIn:Mg(C₅H₅)₂ est 8:4:1, le débit de N₂ est de 80 à 120 sccm, la puissance des micro-ondes est 650 W, la température de dépôt est de 200 à 600°C, la pression de dépôt est de 0,9 à 1,4 Pa, et la durée de dépôt est de 40 à 60 min, la structure à ce moment étant InₓGa₁₋ₓN de type P / film intrinsèque nc-Si:H / nc-Si:H type N / GZO / électrode arrière d'Al / couche isolante AIN / substrat flexible inox.
(7) Préparation de l'autre film conducteur transparent GZO par système de dépôt chimique en phase vapeur assistée par plasma à résonance cyclotron électronique (ECR-PEMOCVD) et introduction de TMGa sous Ar, DEZn et O₂ dans la chambre de réaction ; les paramètres de procédé étant comme suit : le rapport d'écoulement TMGa:DEZn:O₂ est 1:2:80, la puissance des micro-ondes est 650 W, la température de dépôt est de 200 à 400°C, la pression de dépôt est de 0,8 à 1,2 Pa, et la durée de dépôt est de 10 à 20 min, la structure à ce moment étant GZO / InₓGa₁₋ₓN de type P / film intrinsèque nc-Si:H / nc-Si:H type N / GZO / électrode arrière d'Al / couche isolante AIN / substrat flexible inox.
(8) Préparation de l'électrode Al métal par la chambre de réaction à pulvérisation magnétron ; les paramètres de procédé étant comme suit : la source réactionnelle est Ar, le débit d'Ar et 10 à 20 sccm, le matériau cible est l'aluminium, la température du substrat est 50 à 400°C, et la durée de dépôt est de 3 à 10 min, la structure finalement obtenue étant électrode Al / GZO / InₓGa₁₋ₓN de type P / film intrinsèque nc-Si:H / nc-Si:H type N / GZO / électrode arrière d'Al / couche isolante AIN / substrat flexible inox.

2. Procédé de préparation d'une cellule photovoltaïque à substrat en inox avec une structure à puits quantique de bande interdite ajustable selon la revendication 1, **caractérisé en ce que** le matériau cible d'aluminium utilisé pendant la pulvérisation magnétron a une pureté de 99,99 %.
